# EUROPEAN PATENT APPLICATION

(11) **EP 4 645 353 A1**
(43) Date of publication of application: **05.11.2025**
(21) Application number: 24305681.9
(22) Date of filing: 30.04.2024
(51) Int. Cl.: H01F 27/28, H01L 23/00, H01L 23/58, H01F 19/08

(54) **CIRCUIT**

(71) Applicant: NXP USA, Inc., Austin TX 78735 (US)
(72) Inventor: GIOVANNONE, Juri, 5656 AG Eindhoven (NL); BRAUCHLER, Fred T., 5656 AG Eindhoven (NL); ZAHR, Abedel Halim, 31023 Toulouse (FR); FEDERICO, Renato, 5656 AG Eindhoven (NL); MAZEAUD, Thomas, 31023 Toulouse (FR)
(74) Representative: Schmütz, Christian Klaus Johannes

(57) **Abstract**

An electronic circuit, the electronic circuit comprising a first die. The first die comprises a first coil; a second coil; and an electrically conductive loop that defines a first-die region within the loop, wherein the first coil is in the first-die region and the second coil is located outside the first-die region.

## Description

### Field

The present disclosure relates to circuits, including, but not necessarily, electronic circuits on integrated circuits. Some examples of the present disclosure relate to reducing unwanted inductive coupling within multi-channel inductive communication link systems.

### Summary

According to a first aspect of the present disclosure there is provided a circuit, the circuit comprising:
a first die, comprising:
a first coil;
a second coil; and
an electrically conductive loop that defines a first-die region within the loop, wherein the first coil is in the first-die region and the second coil is located outside the first-die region.

Advantageously, the electrically conductive loop provides a current path that can increase the isolation between the first coil and the second coil.

In one or more embodiments:
the first die further comprises:
a first edge seal ring, wherein the first edge seal ring forms an electrically conductive, unbroken perimeter around the first coil and the second coil; and
at least one primary electrically conductive connector connected to the first edge seal ring in two places, such that the at least one primary electrically conductive connector defines two first-die regions within an area defined by the first edge seal ring, wherein the first coil and the second coil are located within different first-die regions.

In one or more embodiments:
the first coil comprises a first-die transmitter coil;
the second coil comprises a first-die receiver coil; and
the circuit further comprises a second die, the second die comprising:
   a second-die receiver coil, which is inductively coupled to the first-die transmitter coil when the circuit is in use; and
   a second-die transmitter coil, which is inductively coupled to the first-die receiver coil when the circuit is in use; and
the circuit further comprises a separator layer, which comprises electrically insulating regions between: the first-die transmitter coil and the second-die receiver coil; and the second-die transmitter coil and the first-die receiver coil.

In one or more embodiments, the circuit is on an integrated circuit.

In one or more embodiments, the first die comprises a plurality of primary electrically conductive connectors that define the two first-die regions.

In one or more embodiments:
the first die comprises a plurality of first-die coils located within at least one of the first-die regions, wherein each first-die coil is either a transmitter coil or a receiver coil;
the second die comprises a plurality of second-die coils, wherein each first-die coil is inductively coupled to a corresponding second-die coil when the circuit is in use; and
the separator layer comprises electrically insulating regions between each pair of corresponding first-die coils and second-die coils.

In one or more embodiments:
the first die comprises a plurality of first-die transmitter coils located within at least one of the first-die regions;
each first-die transmitter coil is separated from each other first-die transmitter coil by at least one secondary electrically conductive connector, connected to the first edge seal ring in two places, such that the at least one secondary electrically conductive connector defines two first-die sub-regions within one of the first-die regions; and
each of the plurality of first-die transmitter coils are located within different first-die sub-regions.

In one or more embodiments:
each first-die transmitter coil is separated from each other first-die transmitter coil by a plurality of secondary electrically conductive connectors.

In one or more embodiments:
the first die further comprises a plurality of first-die receiver coils located within at least one of the first-die regions;
each first-die receiver coil is separated from each other first-die receiver coil by at least one secondary electrically conductive connector, connected to the first edge seal ring in two places, such that the at least one secondary electrically conductive connector defines two first-die sub-regions within one of the first-die regions; and
each of the plurality of first-die receiver coils are located within different first-die sub-regions.

In one or more embodiments:
each first-die receiver coil is separated from each other first-die receiver coil by a plurality of secondary electrically conductive connectors.

In one or more embodiments, the first edge seal ring has a first impedance, and the / each electrically conductive connector of the first die is an electrical conductor with a impedance approximately equal to or less than the impedance of the first edge seal ring.

In one or more embodiments, the second die comprises:
a second edge seal ring, wherein the second edge seal ring forms an unbroken perimeter around the / each second-die transmitter coil and the / each second-die receiver coil; and
at least one primary electrically conductive connector, connected to the second edge seal ring in two places, such that the at least one primary electrically conductive connector defines two second-die regions within an area defined by the second edge seal ring, wherein the second-die transmitter coil and the second-die receiver coil are located within different second-die regions.

In one or more embodiments, the second die comprises a plurality of primary electrically conductive connectors that define the two second-die regions.

In one or more embodiments:
the second die comprises:
   a second edge seal ring, wherein the second edge seal ring forms an electrically conductive, unbroken perimeter around the / each second-die transmitter coil and the / each second-die receiver coil; and
   at least one primary electrically conductive connector, connected to the second edge seal ring in two places, such that the at least one primary electrically conductive connector defines two second-die regions within an area defined by the second edge seal ring, wherein the second-die transmitter coil and the second-die receiver coil are located within different second-die regions; and
each second-die transmitter coil is separated from each other second-die transmitter coil by at least one secondary electrically conductive connector, connected to the second edge seal ring in two places, such that the at least one secondary electrically conductive connector defines two second-die sub-regions within one of the second-die regions; and
each of the plurality of second-die transmitter coils are located within different second-die sub-regions.

In one or more embodiments:
each second-die transmitter coil is separated from each other second-die transmitter coil by a plurality of secondary electrically conductive connectors.

In one or more embodiments:
the second die comprises:
   a second edge seal ring, wherein the second edge seal ring forms an unbroken perimeter around the / each second-die transmitter coil and the / each second-die receiver coil; and
   at least one primary electrically conductive connector, connected to the second edge seal ring in two places, such that the at least one primary electrically conductive connector defines two second-die regions within an area defined by the second edge seal ring, wherein the second-die transmitter coil and the second-die receiver coil are located within different second-die regions; and
each second-die receiver coil is separated from each other second-die receiver coil by at least one secondary electrically conductive connector, connected to the second edge seal ring in two places, such that the at least one secondary electrically conductive connector defines two second-die sub-regions within one of the second-die regions; and
each of the plurality of second-die receiver coils are located within different second-die sub-regions.

In one or more embodiments:
each second-die receiver coil is separated from each other second-die receiver coil by a plurality of secondary electrically conductive connectors.

In one or more embodiments, the second edge seal ring has a first impedance, and the / each electrically conductive connector of the second die is a conductor with an impedance approximately equal to or less than the impedance of the second edge seal ring.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Fig. 1 shows an example implementation of a 4-channel communication link system across a separator layer;
Fig.'s 2a and 2b show an example of how the size of dice can be decreased;
Fig. 3a shows one die of a communication system, which includes a Tx coil, an Rx coil and an edge seal ring;
Fig. 3b shows one die of a communication system according to an embodiment of the present disclosure, which includes a Tx coil, an Rx coil, an edge seal ring and an electrically conductive connector;
Fig. 3c shows another example that includes two coils;
Fig. 3d shows the two coils of Fig. 3c, with an additional electrically conductive loop;
Fig.'s 4a to 4d show one die of some example 4-channel communication link systems implemented on a small die with two transmitter coils and two receiver coils; and
Fig.'s 5a to 5d show one die of some more example 4-channel communication link systems implemented on a small die with two transmitter coils and two receiver coils, according to embodiments of the present disclosure.

### Detailed Description

Galvanic isolation is required in a wide range of electronic applications, including electric vehicles, medical devices, network transceivers, remote sensors, and industrial equipment. Galvanic isolation ensures human safety, improves reliability in harsh environments, reduces noise coupling between subsystems, and eliminates ground loops. Most fundamentally for a functioning system galvanic isolation can be required for communication between voltage domains, especially dramatically varying ones such as driving the high side switches in DC-DC supplies or automotive inverters. Sometimes, different applications have different requirements. For example, in isolated DC-DC power supply modules, high power density and efficiency are required, whereas in automotive inverters, high isolation voltages and long-term reliability are more important. In most applications, isolation barriers are expected to withstand many times their rated operating voltages. Isolation voltages of several kilovolts are typical, and even higher test voltages can be applied during production and type testing.

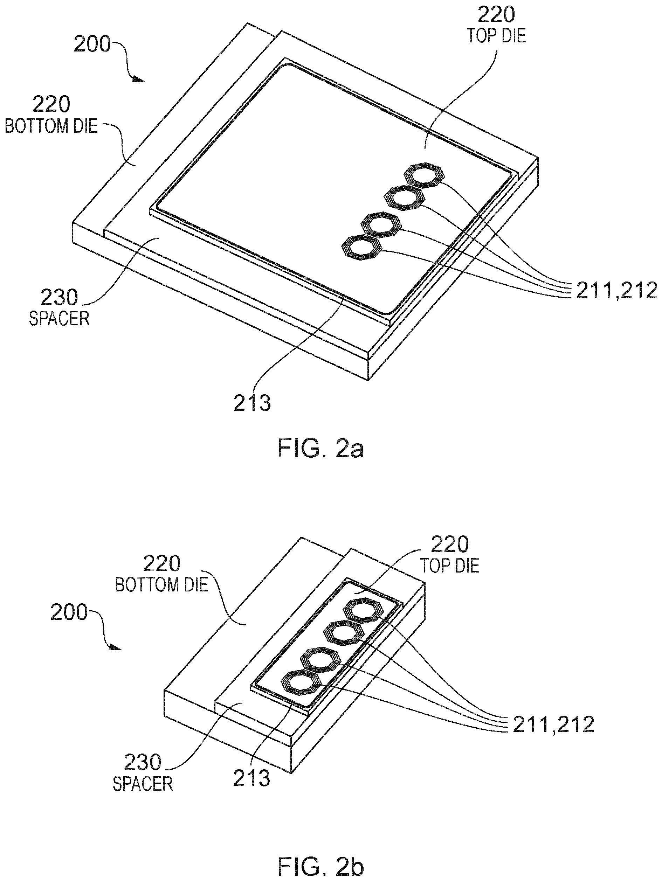

One solution to achieve galvanic isolation in power devices is to use an integrated circuit process with metal layers to form transformer coils separated by an insulator. However, this solution can be affected by some electromagnetic noise driven by some other metal structure present in the die, such as an external sealing ring. In a multi-channel system, this unwanted phenomenon can create some channel-to-channel coupling that can corrupt the data being transmitted. This coupling can be more prevalent in newer devices where a reduction in die size decreases the distance between adjacent coils and to the edge seal ring (which can also be referred to as a die seal ring). This will be described in more detail below with reference to Fig. 2.

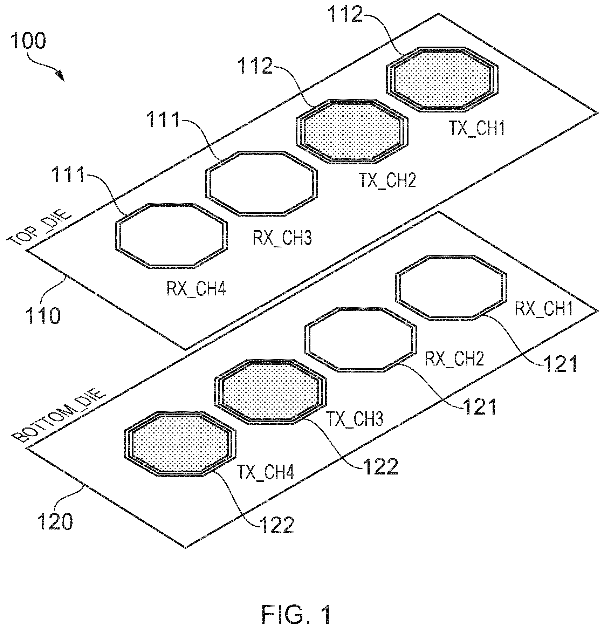

Fig. 1 shows an example implementation of a 4-channel communication link system 100 across a separator layer (not shown). The communication system 100 of Fig. 1 includes a top die 110 and a bottom die 120. The top die 110 is located above the bottom die 120 and a separator layer (not shown) is located between the two dice. In this example, the top die 110 includes two receiver (Rx) coils 111 and two transmitter (Tx) coils 112. The bottom die 120 also includes two Rx coils 121 and two Tx coils 122. The coils 111,112,121,122 are arranged within the dice 110,120 such that, when the top die 110 is located above the bottom die 120: each Rx coil 111 of the top die 110 is located above a corresponding Tx coil 122 of the bottom die 120, and each Tx coil 112 of the top die 110 is located above a corresponding Rx coil 121 of the bottom die 120. Each Tx coil 112,122 can be used to induce a signal in the corresponding Rx coil 121,111 located on the other die. In this way, communication channels can be formed between two dice whilst maintaining galvanic isolation between the dice. This example communication system 100 has four communication channels, although it will be appreciated that any number of communication channels can be used.

Across many different applications of this technology, the demand for increasingly powerful and reconfigurable galvanically isolated devices has led to the development of systems with a greater number of isolated communication channels which are located on smaller dice.

Fig. 2 shows an example of how the size of dice can be decreased. Fig. 2a shows an example implementation of an application which uses isolated communication channels that are implemented on relatively large dice. Fig. 2b shows an example implementation of an application which uses isolated communication channels on relatively small dice. The device shown in Fig. 2b can be considered as a more modern version of the device shown in Fig. 2a.

The applications shown in Fig. 2 each include a top die 210, a bottom die 220, a separator layer 230 (which can also be referred to as a spacer) and four communication channels (visible in Fig. 2 by way of the Tx and Rx coils 211,212 of the top die). The separator layer 230 may be entirely made from, or partially include an electrically isolating material. In any case, the separator layer includes electrically insulating region between the top die and the bottom die.

As shown in Figs. 2a and 2b, each top die 210,220 includes an edge seal ring 213 (the bottom die 220 also includes an edge seal ring, but it is not visible in Fig. 2). The edge seal rings 213 fulfil one or more technical purposes, such as providing a humidity seal to prevent water from interfering with die components or to improve the strength or stability of the physical structure. In this way, the edge seal rings 213 can be considered as providing a mechanical function for protecting the dice. To provide its technical advantages, the edge seal ring 213 forms an unbroken perimeter around some or all of the die components, such as the Tx or Rx coils 211,212 of the communication channels, as required by the application in question. The edge seal ring 213 may be implemented in multiple layers of the structure of the die, thereby forming an unbroken perimeter. The edge seal ring 213 is implemented in electrically conductive layers of the die, for example metallic layers. The edge seal ring 213 of each die may be located at the periphery of its respective die. Alternatively, the edge seal ring 213 may be located further inwards, away from the periphery of its die.

Because the edge seal ring 213 forms an electrically conductive, unbroken perimeter around the coils, it is possible for an active coil to induce a current in the edge seal ring 213. In turn, the induced current in the edge seal ring 213 can induce a current in a coil that is part of a neighbouring communication channel. This can result in the introduction of undesirable electromagnetic interference into any communication channels on the die. This can be especially problematic when the (relatively large) current in a Tx coil is inductively coupled into the edge seal ring 213, which is then inductively coupled into a neighbouring Rx coil (which would usually have a relatively low current). Another problem that is caused by the unwanted induction of currents within a coil is that other circuit components may begin performing operations as a result of this unwanted induced current, thereby interfering with the rest of the circuit.

A relatively large die, such as the one shown in Fig. 2a, can have enough space to facilitate a relatively large separation between the communication coils 211,212 and the edge seal ring 213. Therefore, the induced current in the edge seal ring 213 can be relatively small. This smaller induced current within the edge seal ring 213, and the relatively large separation between the coils and the edge seal ring 213, can reduce the impact that the induced current in the edge seal ring 213 has on the communication coils.

The luxury of space is not available when a relatively small die, such as the one shown in Fig. 2b, is used. In such an example, the die space limitations result in the communication coils 211,212 being located close to each other and/or to the edge seal ring 213, thereby increasing the impact of the electromagnetic interference directly or via the edge seal ring 213 that is described above.

Fig.'s 3a and 3b show one die 310 of two example 2-channel communication systems implemented on a small die with one Tx coil 312 and one Rx coil 311. The die shown in Fig.'s 3a and 3b could be a top die or a bottom die, or any other die within a multi-die system. In Fig.'s 3a and 3b, the unwanted inductive coupling between the coils 312,311 and the edge seal ring 313 is shown with curved arrows. The induced current flow within the edge seal ring 313 is shown with straight arrows.

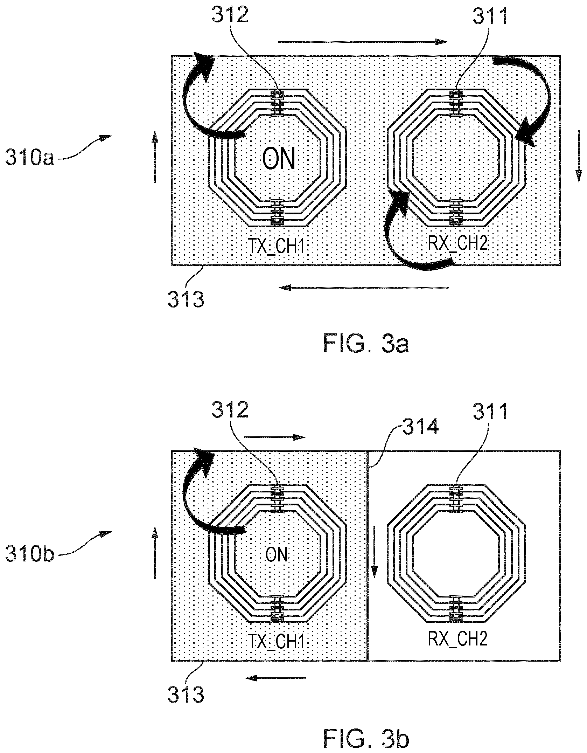

Fig. 3a shows one die 310a of a communication system, which includes a Tx coil 312, an Rx coil 311 and an edge seal ring 313. The edge seal ring 313 forms an electrically conductive, unbroken perimeter around the Tx coil 312 and the Rx coil 311. In such an example, unwanted coupling between the Tx coil 312 and the Rx coil 311, which would normally occur due to the proximity of the coils, is increased further by the presence of the edge seal ring 313. As shown, a current is induced from the Tx coil 312 to the edge seal ring 313 when the Tx coil 312 is active. Moreover, in cases where the edge seal ring 313 is close to the coils 312,311, increasing the separation between the Tx coil 312 and the Rx coil 311 would not affect the interference between the two coils 312,311 because of their proximity to the edge seal ring 313.

Fig. 3b shows one die 310b of a communication system according to an embodiment of the present disclosure, which includes a Tx coil 312, an Rx coil 311, an edge seal ring 313 and an added electrically conductive connector 314. (The die 310a of Fig. 3a does not include an electrically conductive connector.) The edge seal ring 313 forms an electrically conductive, unbroken perimeter around the Tx coil 312 and the Rx coil 311. The electrically conductive connector 314 is connected to the edge seal ring 313 in two places, such that the electrically conductive connector 314 defines two regions within the area defined by the edge seal ring 314. The Tx coil 312 and the Rx coil 311 are located within the different regions defined by the electrically conductive connector 314. In this way, the electrically conductive connector 314 provides a shorter, alternative path for any current which may be induced within the edge seal ring, through which at least some of the induced current will flow.

This alternative current path provided by the electrically conductive connector 314 increases the isolation between the Tx coil 312 and the Rx coil 311. By changing the path of at least some of the induced current in the edge seal ring 313, the induced current travelling close to the Rx coil 311 can be greatly reduced. As a result of this, the current induced within the Rx coil 311 from the edge seal ring 313 (which has been induced into the edge seal ring 313 by the Tx coil 312), and therefore the channel-to-channel interference, is advantageously reduced.

The electrically conductive connector 314 and the portion of the edge seal ring 313 that is adjacent to an active coil can be considered as an electrically conductive loop (which can be any shape) that defines a first-die region within the loop. The active coil is in the first-die region, and the other coil is located outside the first-die region.

The edge seal ring 313 in this example has a first impedance. The electrically conductive connector 314 may have an impedance that is approximately equal to, or less than, the impedance of the edge seal ring 313. This can assist with increasing the proportion of the induced current in the edge seal ring 313 that flows through the electrically conductive connector 314.

Advantageously, the reduction of channel-to-channel interference that is provided by the example of Fig. 3b can be achieved:
i) without the need to cut the edge seal ring. Cutting the edge seal ring can reduce its effectiveness, for example in terms of preventing humidity from reaching the die components;
ii) without increasing the spacing within the die. Increasing the spacing within the die can remove the advantages gained from decreasing the die size; and
iii) without introducing a complex shielding structure. Introducing a complex shielding structure can be costly and space intensive.

In other words, this solution for reducing channel-to-channel interference can be implemented without high additional costs, whilst maintaining the benefits of the reduced silicon area and edge sealing.

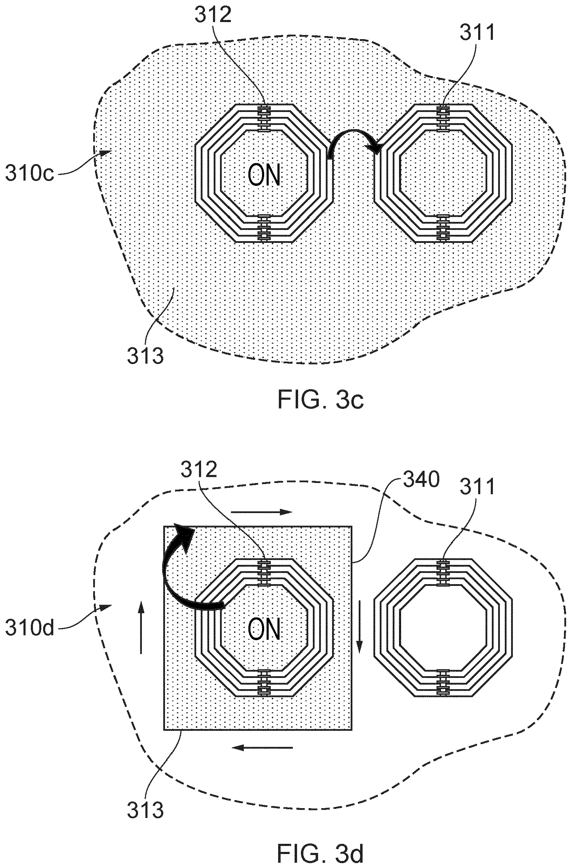

Fig. 3c shows another die 310c that includes two coils 312,311. These coils 312,311 may, or may not, be part of a communication system. For example, they be provided as part of a filter, an impedance matching circuit, or any other circuit that uses coils / inductors. The die 310c may be a die in an integrated circuit or it may be any other surface that includes the two coils 312,311, for example a laminate or a printed circuit board that does not necessarily have an edge seal ring. This is illustrated in Fig. 3c by the portion of the die 310c that is shown having an irregular outline, to signify that it is part of a larger surface. In Fig. 3c, the unwanted inductive coupling between the coils 312,311 is shown with a curved arrow. In a similar way to that described above, it may not be possible to significantly increase the distance between the coils 312,311 because there is often a desire to reduce size.

Fig. 3d shows a die 310d that is similar to the one of Fig. 3c, with an additional electrically conductive loop 340. The electrically conductive loop 340 defines a first-die region within the loop. The first coil 312 is in the first-die region, and the second coil 311 is located outside the first-die region. The induced current flow within the electrically conductive loop 340 is shown with straight arrows. Fig. 3d shows an example of an electronic circuit that does not include an edge seal ring, yet it includes an additional electrical conductor (in this example, the electrically conductive loop 340) to improve the isolation between two coils 312,311 on the die 310d. In this way, the electrically conductive loop 340 of Fig. 3d and the electrically conductive connector 314 of Fig. 3b can improve the shielding between multiple coils / inductors on the same die.

It will be appreciated that multiple electrically conductive loops may be provided on the same die. For example, one, more or all of multiple coils on a die may each have associated electrically conductive loops located around them. Also, one or more of the electrically conductive coils may have a plurality of coils within their perimeter.

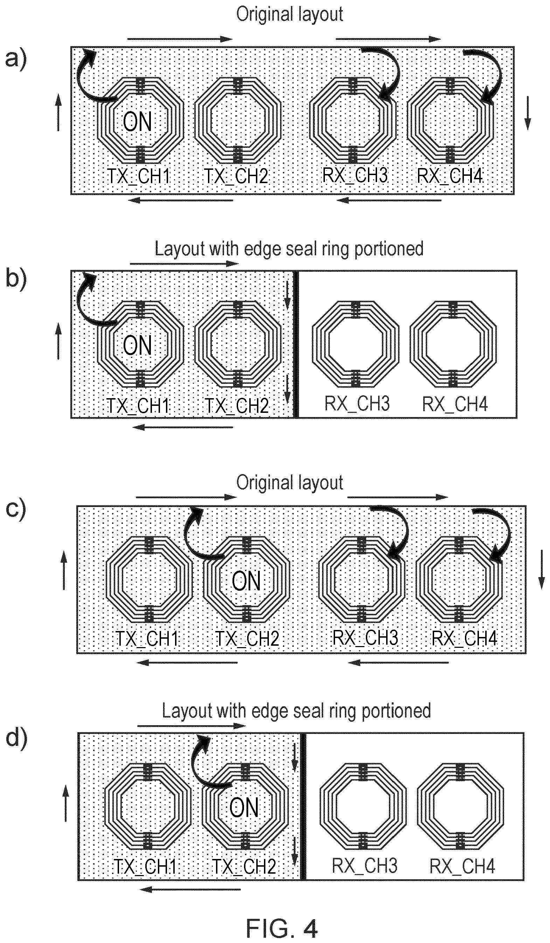

Fig. 4 shows one die of some example 4-channel communication systems implemented on a small die with two Tx coils and two Rx coils. Each channel (and its associated coils) of Fig. 4 is numbered as channel 1 (CH1), channel 2 (CH2), channel 3 (CH3) and channel 4 (CH4) for ease of reference. Figs. 4a and 4b show an example where Tx_CH1 is active, and the resulting induced current in the edge seal ring. Figs. 4c and 4d show an example where Tx_CH2 is active, and the resulting induced current in the edge seal ring. In this example, only one Tx coil is active at any single time, which can further help to reduce the channel-to-channel interference. In Fig. 4, the unwanted inductive coupling between the coils and the edge seal ring is shown with curved arrows and the induced current flow within the edge seal ring is shown with straight arrows.

Figs. 4a and 4c show one die of a communication system which includes two Tx coils, two Rx coils and an edge seal ring, but not an electrically conductive connector. As with the example described with reference to Fig. 3a, the presence of the edge seal ring increases the unwanted coupling between the active Tx coil and the Rx coils.

Figs. 4b and 4d show one die of a 4-channel communication system according to an embodiment of the present disclosure, which includes two Tx coils, two Rx coils, an edge seal ring and an electrically conductive connector. The electrically conductive connector splits the area defined by the edge seal ring into two regions, in a similar way to that described with reference to Fig. 3b. The two Tx coils are located in one of the regions, and the two Rx coils are located in the other region.

As described above with reference to Fig. 3b, the use of the electrically conductive connector increases the isolation between the Tx coils and the Rx coils by changing the path of at least some of the induced current in the edge seal ring. This reduces the proportion of induced current that flows all the way around the edge seal ring. By changing the path of the induced current in the edge seal ring, the induced current travelling close to the Rx coils can be greatly reduced. As a result of this, the current induced within the Rx coils from the edge seal ring (which has been induced in the edge seal ring 313 by the Tx coil 312) is reduced, and therefore the channel-to-channel interference is also reduced.

Depending on the requirements of the application of the communication system, any number of channels can be used, in any appropriate arrangement. It may be desirable to separate all of the Tx coils and Rx coils into different regions defined by the electrically conductive connector. In some examples, the channel-to-channel interference may only be problematic between certain channels, and therefore the specific arrangement of coils and the position of the electrically conductive connector can be managed based on the requirements of any particular application.

In other words, the first die (for example the top die) may include a plurality of first-die coils located within at least one of the first-die regions, wherein each first-die coil is either a transmitter coil or a receiver coil. In this case, the second die (in this example the bottom die) includes a plurality of second-die coils, wherein each first-die transmitter coil is inductively coupled to a corresponding second-die receiver coil when the circuit is in use, and each first-die receiver coil is inductively coupled to a corresponding second-die transmitter coil when the circuit is in use. The separator layer includes electrically insulating regions between each pair of corresponding first-die coils and second-die coils.

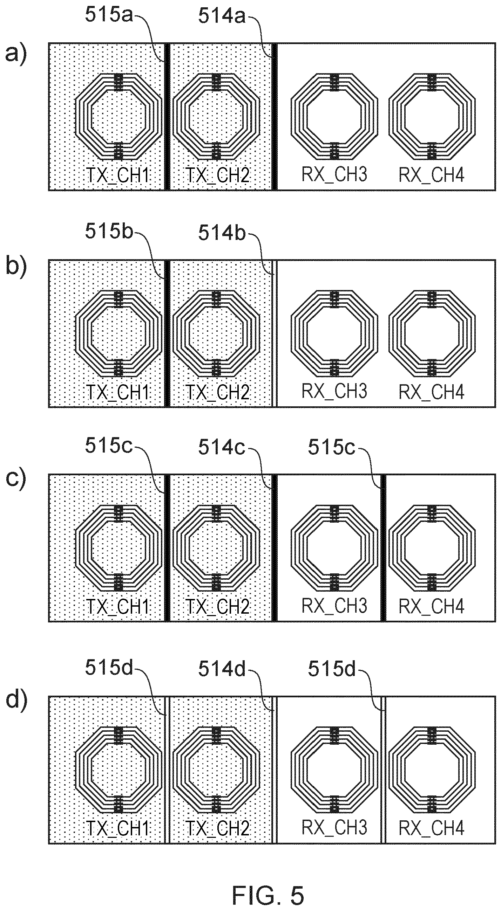

Fig. 5 shows one die of some more example 4-channel communication systems implemented on a die with two Tx coils and two Rx coils, according to embodiments of the present disclosure. The examples in Fig. 5 illustrate that more than one electrically conductive connector can be located in the same die within the same edge seal ring. The multiple electrically conductive connectors can be located such that they isolate individual Tx coils or and / or individual Rx coils, depending on the application requirements. Each electrically conductive connector can also be replaced by two (or more) distinct electrically conductive connectors, as shown in Fig. 5b and as described below.

Fig. 5a shows an embodiment in which the die includes two Tx coils located within one of the regions defined by the electrically conductive connector 514a, which is described above with reference to Fig. 4. We will now refer to this electrically conductive connector 514a as the primary electrically conductive connector 514a. Each Tx coil is separated from the other Tx coil by a secondary electrically conductive connector 515a, which is connected to the first edge seal ring in two places. The secondary electrically conductive connector 515a defines two sub-regions within the region containing the Tx coils. The primary electrically conductive connector 514a and the secondary electrically conductive connector 515a can be the same as each other in structure, or they can be different; the different names are simply used for ease of description. Each of the plurality of transmitter coils are located within different sub-regions in this example. In this way, the isolation of the Tx coils can be increased further. By improving the isolation between each Tx coil, it can be possible for two adjacent Tx coils to be active at the same time without significantly interfering with each other.

Although Fig. 5a only illustrates an example with two Tx coils, it will be appreciated that any number of Tx coils can be included. In this way, the die may include a plurality of Tx coils located within at least one of the regions defined by the primary electrically conductive connector 514a. In such an example, each Tx coil may be separated from one, some, or all of the other Tx coils by at least one secondary electrically conductive connector 515a in the same way as described above. In some examples, multiple Tx coils may be located in a single sub-region defined by at least one secondary electrically conductive connector.

Fig. 5b shows an embodiment similar to Fig. 5a, in which the primary electrically conductive connector has been replaced with two primary electrically conductive connectors 514b. In this example, the two primary electrically conductive connectors 514b of Fig. 5b are arranged parallel to one another, with no other components in between. In other embodiments, the two primary electrically conductive connectors 514b may not be parallel, and there may be other components located in between them. In further embodiments still, the primary electrically conductive connector of Fig. 5a can be replaced with more than two primary electrically conductive connectors. Therefore it can be said that, in some embodiments, the die includes a plurality of primary electrically conductive connectors that define the two regions. The use of a plurality of primary electrically conductive connectors can allow the distance between a primary electrically conductive connector (and therefore the current path of an induced current within the edge seal ring) and the coils located on the die to be controlled. Additionally, the plurality of electrically conductive connectors provides more alternative paths for induced currents, thereby improving the channel-to-channel isolation of the device.

Fig. 5c shows an embodiment in which the die includes two Rx coils located within one of the regions defined by the primary electrically conductive connector 514c. Each Rx coil is separated from the other Rx coil by a secondary electrically conductive connector 515c that defines two sub-regions within the region containing the Rx coils. Each of the Rx coils are located within different sub-regions.

Although Fig. 5c displays an example with two Rx coils, it will be appreciated that any number of Rx coils can be included. In this way, the die may include a plurality of Rx coils located within at least one of the regions defined by the primary electrically conductive connector. In such an example, each Rx coil may be separated from one, some, or all of the other Rx coils by at least one secondary electrically conductive connector 515c in the same way as described above. In some examples, multiple Rx coils may be located in a single sub-region defined by at least one secondary electrically conductive connector.

In a similar way to the primary electrically conductive connectors 514b that are described above with reference to Fig. 5b, each secondary electrically conductive connector may be replaced by a plurality of secondary electrically conductive connectors. In such cases, the same advantages, described above with reference to Fig. 5b, still apply. Therefore it can be said that, in embodiments which include a plurality of Tx coils, each Tx coil can be separated from one or more of the other Tx coils by a plurality of secondary electrically conductive connectors. In some embodiments which include a plurality of Rx coils, each Rx coil can be separated from one or more of the other Rx coils by a plurality of secondary electrically conductive connectors.

In embodiments which include a plurality of Rx coils and a plurality of Tx coils, some Rx coils may be separated from other Rx coils by secondary electrically conductive connectors, whilst no Tx coils are separated from other Tx coils on the die.

Fig. 5d shows an embodiment of a die that is very similar to the one of Fig. 5c. The only differences are that each of the conductive connectors (that is, the primary conductive connector and the two secondary conductive connectors) are implemented as a pair of parallel conductive connectors 514d,515d. Advantages associated with using a pair of parallel conductive connectors are described with reference to Fig. 5b. It will be appreciated that any arrangement of Tx coils, Rx coils, primary electrically conductive connectors and secondary electrically conductive connectors can be used to align with the specific requirements of a particular application, whilst retaining the benefits provided by this disclosure.

Although Figs. 3-5, and the discussion thereof, have been directed towards a single die, it will be appreciated that the techniques and methods presented in this disclosure can be implemented on more than one die of a multi-die application (for example, an application including a top die and a bottom die), according to the specific requirements of the application in question.

Some illustrative examples of a two-die application will now be discussed.

In a first example, the first die, includes a first-die Tx coil, a first-die Rx coil and a first edge seal ring which forms an electrically conductive, unbroken perimeter around the first-die Tx coil and the second-die Rx coil. The first die also includes at least one primary electrically conductive connector connected to the first edge seal ring in two places, such that the at least one primary electrically conductive connector defines two first-die regions within an area defined by the first edge seal ring, wherein the first-die Tx coil and the first-die Rx coil are located within different first-die regions.

The second die includes a second-die Rx coil, which is inductively coupled to the first-die Tx coil and a second-die Tx coil, which is inductively coupled to the first-die receiver coil when the electronic circuit is in use.

This example also includes a separator layer, with electrically insulating regions between: the first-die Tx coil and the second-die Rx coil; and the second-die Tx coil and the first-die Rx coil.

In this example, the second die also includes a second edge seal ring which forms an unbroken perimeter around the second-die Tx coil and second-die Rx coil, and at least one primary electrically conductive connector, connected to the second edge seal ring in two places, such that the at least one primary electrically conductive connector defines two second-die regions within an area defined by the second edge seal ring, wherein the second-die Tx coil and the second-die Rx coil are located within different second-die regions. This allows for the same advantages discussed above with reference to Figs. 3-5 to be achieved by the second die in this two-die application.

The first and / or the second die can be implemented in any of the ways that are described above with reference to Figs. 3-5.

One or more of the solutions proposed by this disclosure can enhance isolation between nearby Tx/Rx channel coils and the edge seal ring. Such solutions can be used in a CMOS technology structure, any other semiconductor structure, or even other laminate or printed circuit boards where a top coil is in some layers and a bottom coil is in other layers. Such solutions can increase the performance of associated isolated communication links. This can address the problem of possible couplings between the Tx and Rx coils of different channels and the structure of the die seal ring through the partition that is provided by the electrically conductive connectors that are described above. These electrically conductive connectors provide short circuits, which are created to reduce the areas where induced currents can circulate by using low impedance metal structures. This solution can show an even greater benefit within a system of multiple coils which are close together and close to an edge seal ring.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A circuit, the circuit comprising:
a first die, comprising:
a first coil;
a second coil; and
an electrically conductive loop that defines a first-die region within the loop, wherein the first coil is in the first-die region and the second coil is located outside the first-die region.

2. The circuit of claim 1, wherein:
the first die further comprises:
a first edge seal ring, wherein the first edge seal ring forms an electrically conductive, unbroken perimeter around the first coil and the second coil; and
at least one primary electrically conductive connector connected to the first edge seal ring in two places, such that the at least one primary electrically conductive connector defines two first-die regions within an area defined by the first edge seal ring, wherein the first coil and the second coil are located within different first-die regions.

3. The circuit of claim 2, wherein:
the first coil comprises a first-die transmitter coil;
the second coil comprises a first-die receiver coil; and
the circuit further comprises a second die, the second die comprising:
a second-die receiver coil, which is inductively coupled to the first-die transmitter coil when the circuit is in use; and
a second-die transmitter coil, which is inductively coupled to the first-die receiver coil when the circuit is in use; and
the circuit further comprises a separator layer, which comprises electrically insulating regions between: the first-die transmitter coil and the second-die receiver coil; and the second-die transmitter coil and the first-die receiver coil.

4. The circuit of claim 3, wherein the circuit is on an integrated circuit.

5. The circuit of claim 3 or claim 4, wherein the first die comprises a plurality of primary electrically conductive connectors that define the two first-die regions.

6. The circuit of any one of claims 3 to 5, wherein:
the first die comprises a plurality of first-die coils located within at least one of the first-die regions, wherein each first-die coil is either a transmitter coil or a receiver coil;
the second die comprises a plurality of second-die coils, wherein each first-die coil is inductively coupled to a corresponding second-die coil when the circuit is in use; and
the separator layer comprises electrically insulating regions between each pair of corresponding first-die coils and second-die coils.

7. The circuit of claim 6, wherein:
the first die comprises a plurality of first-die transmitter coils located within at least one of the first-die regions;
each first-die transmitter coil is separated from each other first-die transmitter coil by at least one secondary electrically conductive connector, connected to the first edge seal ring in two places, such that the at least one secondary electrically conductive connector defines two first-die sub-regions within one of the first-die regions; and
each of the plurality of first-die transmitter coils are located within different first-die sub-regions.

8. The circuit of claim 7, wherein:
each first-die transmitter coil is separated from each other first-die transmitter coil by a plurality of secondary electrically conductive connectors.

9. The circuit of claim 6, wherein:
the first die further comprises a plurality of first-die receiver coils located within at least one of the first-die regions;
each first-die receiver coil is separated from each other first-die receiver coil by at least one secondary electrically conductive connector, connected to the first edge seal ring in two places, such that the at least one secondary electrically conductive connector defines two first-die sub-regions within one of the first-die regions; and
each of the plurality of first-die receiver coils are located within different first-die sub-regions.

10. The circuit of claim 9, wherein:
each first-die receiver coil is separated from each other first-die receiver coil by a plurality of secondary electrically conductive connectors.

11. The circuit of any one of claims 3 to 10, wherein the first edge seal ring has a first impedance, and the / each electrically conductive connector of the first die is an electrical conductor with a impedance approximately equal to or less than the impedance of the first edge seal ring.

12. The circuit of any one of claims 3 to 11, wherein the second die comprises:
a second edge seal ring, wherein the second edge seal ring forms an unbroken perimeter around the / each second-die transmitter coil and the / each second-die receiver coil; and
at least one primary electrically conductive connector, connected to the second edge seal ring in two places, such that the at least one primary electrically conductive connector defines two second-die regions within an area defined by the second edge seal ring, wherein the second-die transmitter coil and the second-die receiver coil are located within different second-die regions.

13. The circuit of claim 9, wherein:
the second die comprises:
a second edge seal ring, wherein the second edge seal ring forms an electrically conductive, unbroken perimeter around the / each second-die transmitter coil and the / each second-die receiver coil; and
at least one primary electrically conductive connector, connected to the second edge seal ring in two places, such that the at least one primary electrically conductive connector defines two second-die regions within an area defined by the second edge seal ring, wherein the second-die transmitter coil and the second-die receiver coil are located within different second-die regions; and
each second-die transmitter coil is separated from each other second-die transmitter coil by at least one secondary electrically conductive connector, connected to the second edge seal ring in two places, such that the at least one secondary electrically conductive connector defines two second-die sub-regions within one of the second-die regions; and
each of the plurality of second-die transmitter coils are located within different second-die sub-regions.

14. The circuit of claim 7, wherein:
the second die comprises:
a second edge seal ring, wherein the second edge seal ring forms an unbroken perimeter around the / each second-die transmitter coil and the / each second-die receiver coil; and
at least one primary electrically conductive connector, connected to the second edge seal ring in two places, such that the at least one primary electrically conductive connector defines two second-die regions within an area defined by the second edge seal ring, wherein the second-die transmitter coil and the second-die receiver coil are located within different second-die regions; and
each second-die receiver coil is separated from each other second-die receiver coil by at least one secondary electrically conductive connector, connected to the second edge seal ring in two places, such that the at least one secondary electrically conductive connector defines two second-die sub-regions within one of the second-die regions; and
each of the plurality of second-die receiver coils are located within different second-die sub-regions.

15. The circuit of any of claims 12-14, wherein the second edge seal ring has a first impedance, and the / each electrically conductive connector of the second die is a conductor with an impedance approximately equal to or less than the impedance of the second edge seal ring.
